# EUROPÄISCHE PATENTSCHRIFT

(11) **EP 0 888 227 B1**
(45) Veröffentlichungstag und Bekanntmachung des Hinweises auf die Patenterteilung: **07.11.2001**
(21) Anmeldenummer: 97916341.7
(22) Anmeldetag: 11.03.1997
(51) Int. Cl.: B60R 21/32

(54) **ZÜNDEINRICHTUNG ZUM AUSLÖSEN EINES RÜCKHALTEMITTELS IN EINEM KRAFTFAHRZEUG**
IGNITION DEVICE FOR RELEASE OF RESTRAINING MEANS IN A MOTOR VEHICLE
DISPOSITIF D'ALLUMAGE PERMETTANT DE LIBERER UN SYSTEME DE RETENUE DANS UN VEHICULE A MOTEUR

(30) Priorität: 19.03.1996 DE 19610799
(43) Veröffentlichungstag der Anmeldung: 07.01.1999
(73) Patentinhaber: SIEMENS AKTIENGESELLSCHAFT, 80333 München (DE)
(72) Erfinder: GRUBER, Robert, D-93057 Regensburg (DE); CHRISTOPH, Markus, D-93055 Regensburg (DE); DIRMEYER, Josef, D-92439 Bodenwöhr (DE); WAGNER, Egbert, D-93161 Sinzing (DE); PROBST, Heinrich, D-93105 Tegernheim (DE); PLANKL, Christian, D-93055 Burgweinting (DE)
(86) Internationale Anmeldenummer: DE9700475
(87) Internationale Veröffentlichungsnummer: WO9734786

(56) Entgegenhaltungen:
- DE-A- 4 300 342
- DE-A- 4 339 347
- DE-A- 4 414 743
- GB-A- 2 245 775

## Beschreibung

Die Erfindung betrifft eine Zündeinrichtung zum Auslösen eines Rückhaltemittels in einem Kraftfahrzeug gemäß Oberbegriff von Patentanspruch 1.

Aus der Druckschrift EP 0 471 871 A1 ist ein System zum Auslösen eines Rückhaltemittels in einem Kraftfahrzeug bekannt. Dieses System weist eine zentral im Fahrzeug angeordnete Auswerteeinheit zum Auswerten von Beschleunigungs-/Crashsignalen auf, die von einer Sensoreinrichtung geliefert werden. Zündschaltungen enthaltende Zündeinrichtungen, die nahe bei den zugeordneten Rückhaltemitteln wie Airbag, Gurtstraffer, usw. angeordnet sind, sind über eine Leitung/Bus mit der Auswerteeinheit verbunden. Erkennt die Auswerteeinheit einen Unfall, bei dem zumindest eines der Rückhaltemittel ausgelöst werden soll, so wird ein codierter Auslösebefehl von der Auswerteeinheit an die entsprechende Zündeinrichtung übermittelt. In der Zündschaltung der Zündeinrichtung wird der Auslösebefehl decodiert und in Steuerbefehle umgesetzt, durch die die in einem Energiespeicherkondensator der Zündeinrichtung gespeicherte Energie auf ein mit der Zündeinrichtung elektrisch verbundenes Zündelement/Zündpille des Rückhaltemittels übertragen wird.

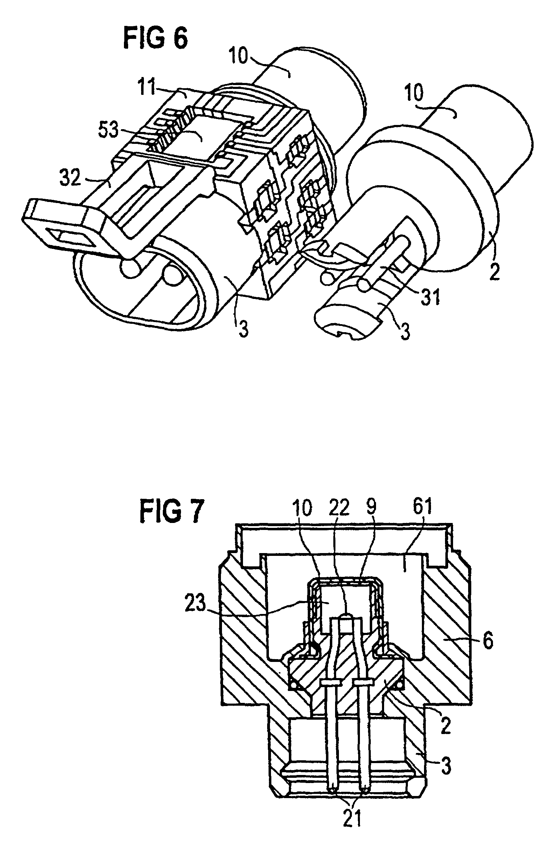

Eine herkömmliches Zündelement in Form einer Zündpille 2 gemäß Figur 7 der vorliegenden Patentanmeldung weist zwei Zündanschlußstifte 21 auf, die über einen Zünddraht 22 verbunden sind. Der Zünddraht 22 ist in einer Zündkammer 23 angeordnet, die durch einen Träger der Zündpille 2 sowie einer Kunststoffkappe 9 gebildet wird. Die Zündkammer 23 ist mit einem Zündpulver angefüllt, das bei genügend starker Erwärmung des Zünddrahtes 22 explodiert und den Deckel der Kunststoffkappe 9 wegsprengt. Der Mantel der Kunststoffkappe 9 ist von einer Metallkappe 10 umgeben, die eine elektromagnetische Einstrahlung auf die Zündanschlußstifte 21 und den Zünddraht 22 verhindern soll. Ein Unterteil eines Gasgeneratormantels 6 umgibt die Zündpille 2 und bildet gleichzeitig einen Steckerkörper 3 für die Zündanschlußstifte 21. Der Gasgeneratormantel 6 umschließt eine Generatorkammer 61, in der nicht gezeigte Tabletten angeordnet sind, die aufgrund der Explosion des Zündpulvers in der Zündkammer 23 mit Energie versorgt werden und daraufhin Gase freisetzen, welche einen an den Gasgenerator angeschlossenen Luftsack/Airbag anfüllen. Über die Steckverbindung wird die Zündpille 2 elektrisch leitend mit einer zentral im Fahrzeug angeordneten Auswerteeinheit verbunden, wobei über die Leitung zwischen Auswerteeinheit und Zündpille ein ausreichend Energie tragender Zündimpuls zum Auslösen des zugeordneten Rückhaltemittels übertragen wird.

Die bekannte Zündpille weist üblicherweise eine zwischen den Zündanschlußstiften 21 angeordnete - in Figur 7 nicht gezeigte - Kurzschlußbrücke auf. Eine solche Kurzschlußbrücke verhindert vor Aufstecken eines Gegensteckers auf die Zündpille 2 ein ungewolltes Zünden des Zündpulvers durch versehentliches Beaufschlagen der aus dem Steckerkörper 3 herausragenden Zündanschlußstifte 21 mit Gleichspannung.

Aus der DE 44 14 743 ist eine Anordnung bekannt, bei der ein herkömmliches getrennt hergestelltes Zündelement/Zündpille mit Anschlußdrähten auf einer Leiterplatte montiert wird.

Die GB 2 245 775 offenbart eine Anordnung bei der ein Stecker auf einer Leiterplatte montiert ist der über eine Buchse und Anschlußkabel mit einer Zündpille verbunden ist.

Aufgabe der Erfindung ist es deshalb, die Nachteile der bekannten Zündpille zu vermeiden und insbesondere die bekannte Zündeinrichtung konstruktiv derart auszubilden, daß sie äußerst geringe Abmessungen aufweist, um beispielsweise auch im Lenkrad angebracht werden zu können, zudem eine geringe Anzahl von Bauteilen benötigt, und überdies einfach herzustellen ist.

Diese Aufgabe wird durch die Merkmale des Patentanspruchs 1 gelöst.

Dabei enthält ein die Zündschaltung tragender Träger Zündanschlußstifte zur Aufnahme eines Zündelements. Ein mit dieser Zündeinrichtung verbundenes Zündelement weist beispielsweise im wesentlichen den Aufbau der bekannten Zündpille auf, wobei anstelle der aus dem Zündpillenkörper herausragenden Zündanschlußstifte Buchsen zur Aufnahme der nun an der Zündeinrichtung befestigten Zündanschlußstifte vorgesehen sind. Erfindungsgemäß enthält die Zündeinrichtung also einen vorzugsweise räumlichen Schaltungsträger, in den zumindest die Zündanschlußstifte integriert sind.

Damit kann der Kurzschlußbügel von herkömmlichen Zündpillen entfallen.

Vorzugsweise wird der als üblicherweise als Glühdraht ausgebildete Zünddraht gleich direkt an den aus dem Schaltungsträger herausragenden Zündanschlußstiften befestigt. Damit entfällt die Zündpille gemäß Figur 7 als bauliche Einheit zum Aufstecken auf die Zündeinrichtung. Die Zündanschlußstifte sind erfindungsgemäß in jedem Fall integraler Bestandteil des Schaltungsträgers, der die Zündschaltung aufnimmt. Auch bei dieser vorteilhaften Weiterbildung entfällt insbesondere der bei herkömmlichen Zündpillen für das gefahrenlose Handling unabdingbare Kurzschlußbügel. Zündpille und Zündeinrichtung sind erfindungsgemäß nicht mehr über eine Steckverbindung elektrisch und mechanisch miteinander verbunden. Als integraler Bestandteil des Schaltungsträgers der Zündeinrichtung werden die Zündanschlußstifte bei Erstellung des Trägers gleich mit angefertigt.

Erst in einem weiteren Schritt wird der Zünddraht mit den Zündanschlußstiften verpreßt, verlötet, verklebt oder einfach um die Zündanschlußstifte gewickelt (wire-wrap-Verbindung). Daraufhin wird die als Umgebung des Zünddrahts definierte Zündkammer mit pyrotechnischem Zündpulver gefüllt.

Die Zündeinrichtung enthält vorzugsweise Steckeranschlußstifte, welche ebenfalls integraler Bestandteil des Trägers sind. ,Über diese Steckeranschlußstifte und einen entsprechenden Steckverbinder ist die Zündeinrichtung über einen Bus mit der Auswerteeinheit verbunden. Werden die Steckeranschlußstifte der Zündeinrichtung vor dem Verbinden der Zündeinrichtung mit der Auswerteeinheit versehentlich mit Spannung beaufschlagt, so wird der Zünddraht aufgrund der den Zündanschlußstiften vorgeschalteten Zündschaltung nicht erhitzt und so eine Fehlauslösung des Rückhaltemittels verhindert. Aufgrund der baulichen Einheit von Zündanschlußstiften und Schaltungsträger erübrigt sich die Notwendigkeit eines Kurzschlußbügels zwischen den Zündanschlußstiften.

Zudem wird zudem Bauraum gewonnen, da eine Steckverbindung zwischen herkömmlicher Zündpille und einer herkömmlichen Zündeinrichtung ohne integrierte Zündanschlußstifte entfällt.

Bei einer besonders vorteilhaften Weiterbildung der Erfindung ist der Träger als eine aus einem Metallband gestanzte Leiterbahnstruktur ausgebildet, wobei die Zündanschlußstifte Bestandteil der Leiterbahnstruktur sind. Aufgrund einer vorteilhaften dreidimensionalen Form der Leiterbahnstruktur sowie einer ebenfalls einstückigen Ausbildung der Steckeranschlußstifte mit der Leiterbahnstruktur wird die gesamte Zündeinrichtung äußerst kompakt, sodaß sie selbst im Lenkrad oder der Seitentür des Fahrzeugs Platz findet.

In einer weiteren vorteilhaften Weiterbildung der Erfindung ist der Träger als dreidimensionaler Kunststoffkörper mit aufgebrachten Leiterbahnen ausgebildet, wobei die Zündanschlußstifte fest mit dem Kunststoffkörper verbunden sind, also vorzugsweise umspritzt und damit unlösbar mit dem Kunststoffkörper verbunden sind. Alternativ sind die Zündanschlußstifte als metallisierte Flächen des Kunststoffkörpers ausgebildet. Hinsichtlich der Kompaktheit der Zündeinrichtung ist es auch hier vorteilhaft, Steckeranschlußstifte gleich als integralen Bestandteil des Trägers mitauszubilden, wie im übrigen bezüglich der Vorteile dieser Weiterbildung auf die Vorteile der vorbeschriebenen Weiterbildung der Erfindung verwiesen wird.

Aufgrund des dreidimensionalen Schaltungsträgers ist die gesamte Zündeinrichtung in ihrer räumlichen Ausbildung frei gestaltbar und kann damit sowohl an die räumlichen Gegebenheiten des Einbauortes als auch an die mechanischen Schnittstellen zum Gasgenerator wie auch an die Steckerschnittstelle zum Bus äußerst einfach angepaßt werden.

Weitere vorteilhafte Weiterbildungen sind in den Unteransprüchen gekennzeichnet.

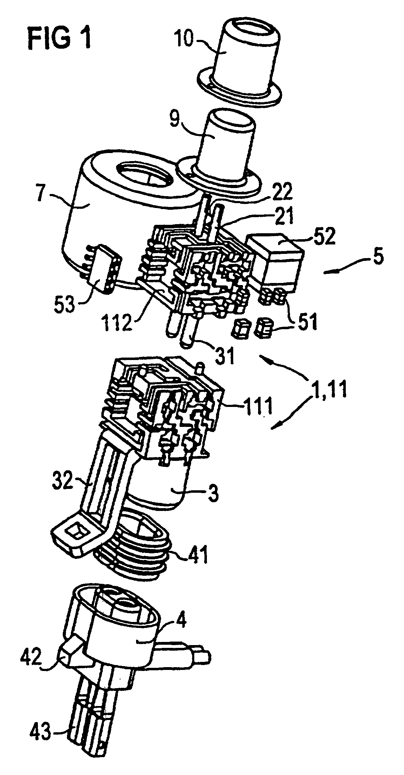

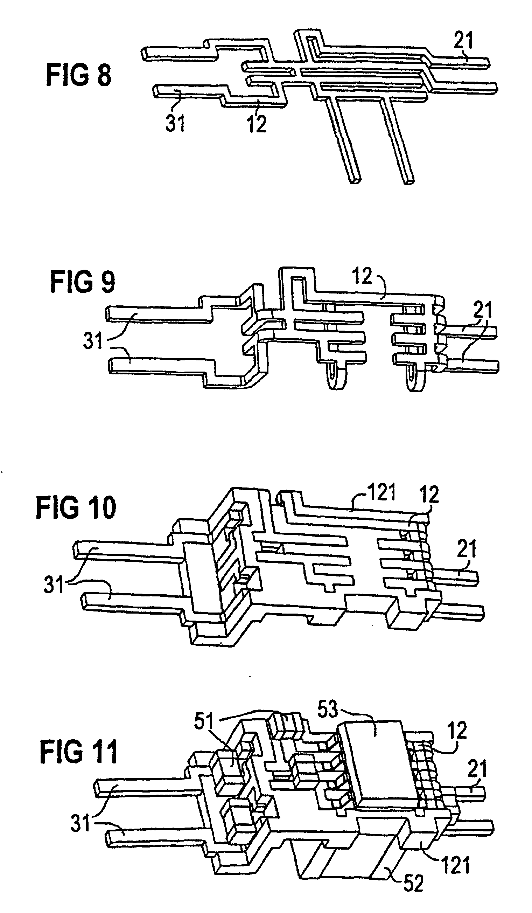

Die Erfindung und ihre Weiterbildungen werden anhand der Figuren 1 bis 13 näher erläutert, wobei die Figuren 1 bis 6 eine Zündeinrichtung mit einem dreidimensionalen Kunststoffkörper als Schaltungsträger offenbaren, die Figuren 8 bis 13 dagegen eine Zündeinrichtung mit einem Stanzgitter/Leadfraeme als Schaltungsträger. Es zeigen im einzelnen:
- Figur 1:: eine erfindungsgemäße Zündeinrichtung mit Gegenstekker und diversen Ummantelungen in Explosionsdarstellung,
- Figur 2:: die Zündeinrichtung gemäß Figur 1 in Explosionsdarstellung, mit einigen bereits zusammengesetzten Bauteilen, mit Gegenstecker und mit einer Metall- und einer Kunststoffkappe,
- Figur 3 und 5:: die vollständig zusammengesetzte Zündeinrichtung gemäß Figur 2 in perspektivischer Ansicht, mit vorgenannten zusätzlichen Bauteilen,
- Figur 4:: die vollständig zusammengesetzte Zündeinrichtung gemäß Figur 2,
- Figur 6:: die Zündeinrichtung mit Kunststoff- und Metallkappe in perspektivischer Ansicht neben einer bekannten Zündpille,
- Figur 7:: das Schnittbild durch eine bekannte Zündpille, umgeben von einem Gasgenerator-Unterteil,
- Figur 8:: eine Leiterbahnstruktur als Träger für eine Zündschaltung,
- Figur 9:: die zu einem dreidimensionalen Schaltungsträger gebogene Leiterbahnstruktur gemäß Figur 8,
- Figur 10:: die Leiterbahnstruktur gemäß Figur 9, umspritzt mit Kunststoffbrücken,
- Figur 11:: die umspritzte Leiterbahnstruktur gemäß Figur 10, bestückt mit Bauelementen,
- Figur 12:: eine Explosionsdarstellung der erfindungsgemäßen Zündeinrichtung in Stanzgitter-Technik, mit Gegenstecker und diversen Ummantelungen, und
- Figur 13:: eine zusammengebaute Zündeinrichtung mit Gegenstekker und Ummantelungen gemäß Figur 12.

Gleiche Elemente/Bauteile in den Figuren werden figurenübergreifend durch die selben Bezugszeichen gekennzeichnet.

In Figur 1 ist eine Zündeinrichtung mit diversen Ummantelungen 7, 9, 10 und einem Gegenstecker 4 explosionsartig dargestellt. Die Zündeinrichtung enthält dabei einen Träger 1, der als dreidimensionaler Kunststoffkörper 11 ausgebildet ist. Der dreidimensionale Kunststoffkörper 11 ist aus zwei Kunststoffkomponenten hergestellt: Ein Isolierkörper 111 aus einer ersten Kunststoffkomponente bildet das Gerüst des Kunststoffkörpers 11. Um diesen Isolierkörper 111 herum wird in einer weiteren Kunststoffkomponente ein Leiterbahnkörper 112 gespritzt - Isolierkörper 111 und Leiterbahnkörper 112 werden gemäß Figur 1 also nicht ineinander geschoben, sondern ergänzen bzw. ummanteln einander im Sinne eines Aufspritzen des Leiterbahnkörpers 112 auf den Isolierkörper 111. Die weitere Kunststoffkomponente, aus der der Leiterbahnkörper 112 hergestellt wird, weist im Gegensatz zur ersten Kunststoffkomponente die Eigenschaft auf, daß ihre Oberfläche metallisiert werden kann. In einem weiteren Herstellungsschritt werden also insbesondere die Oberflächen des Leiterbahnkörpers 112, die am Kunststoffkörper 11 zugänglich sind, zu Leiterbahnen 113 metallisiert.

Anstelle des vorbeschriebenen Zwei-Komponenten-Spritzgusses "MID" des Kunststoffkörpers 11 kann der Kunststoffkörper 11 auch aus einer einzigen Kunststoffkomponente gespritzt werden. Auf diesen Kunststoffkörper 11 werden dann im folgenden Leiterbahnen 113 durch Laserdirektbelichtung, 3D-Maskenbelichtung oder Heißprägen aufgebracht.

Der so entstandene Kunststoffkörper 11 als Schaltungsträger 1 für eine Zündschaltung 5 wird daraufhin mit elektronischen Bauelementen wie insbesondere Energiespeicherkondensator 50 oder integrierte Schaltung 53 bestückt. Diese Bauelemente können - wie auch weitere Bauelemente 51 - als SMD-Bauelemente (Surface mounted device) ausgebildet sein, so daß eine SMD-Bestückung des Trägers durch einen SMD-Standard-Bestückungsautomaten ermöglicht wird. An den Isoliertkörper 111 ist ein Steckerkörper 3 zur Aufnahme eines Gegensteckers 4 mitangespritzt. Der Gegenstecker 4 weist eine Rastnase 42 auf, die bei zusammengesteckter Steckverbindung 3,4 in einen Rasthaken 32, der ebenfalls zusammen mit dem Isolierkörper 111 in einem Spritzvorgang hergestellt wird, eingerastet ist. Ein Dichtring 41 aus Silikon dichtet die Steckverbindung 3,4 gegen Wasser ab. Mit Verriegelungselementen 43 kann die Steckverbindung 3,4 zusätzlich verriegelt werden.

Steckeranschlußstifte 31, die zumindest teilweise von dem Steckerkörper 3 umgeben sind, und Zündanschlußstifte 21 sind zumindest teilweise in den Kunststoffkörper 11 eingebettet und damit unlösbar mit diesem verbunden. Die Zündanschlußstifte 21 sind über einen Zündraht 22 elektrisch leitend miteinander verbunden. Der aus dem Kunststoffkörper 11 herausragende Teil der Zündanschlußstifte inklusive Zünddraht 22 ist von einer Kunststoffkappe 9 und im weiteren von einer Metallkappe 10 umgeben. Die Kunststoffkappe 9 dient zur Aufnahme von Zündpulver, das bei genügender Erwärmung des Zünddrahtes 22 explodiert.

Die Metallkappe 10 schützt die Zündanschlußstifte 21 sowie den Zünddraht 22 vor elektromagnetischer Einstrahlung. Die Metallkappe 10 weist keinen Deckel auf, sodaß beim Explodieren des Zündpulvers in der Kunststoffkappe 9 der Deckel der Kunststoffkappe 9 weggesprengt wird und die freiwerdende Energie durch die Metallkappe 10 entweichen kann. Dagegen wird über die Steckeranschlußstifte 31 gelieferte elektromagnetische Strahlung durch entsprechende Schaltungsteile der Zündschaltung 5 ausgefiltert.

Ein Kunststoffmantel 7 umgibt im zusammengebauten Zustand der Zündeinrichtung den Träger 1 und schützt diesen insbesondere vor Feuchtigkeit, Wasser und Gasen und der damit verbundenen Oxidation/Korrosion. Vorzugsweise wird der mit Bauelementen 51 bis 53 bestückte Kunststoffkörper 11/Träger 1 mit isolierendem Kunststoff umspritzt, so daß der Kunststoffmantel 7 gemäß Figur 1 entsteht.

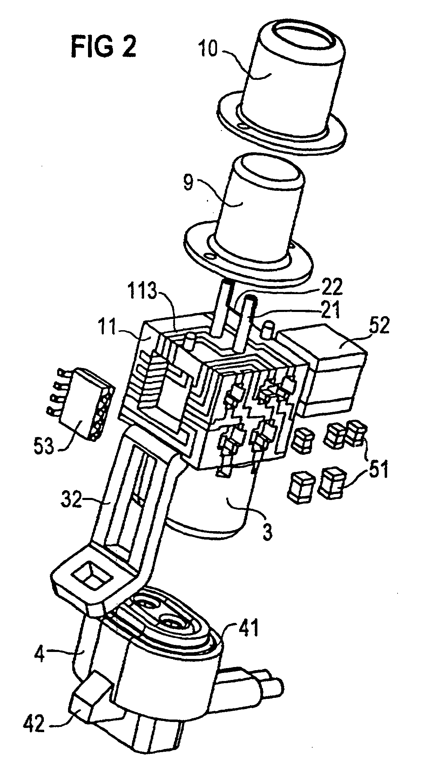

Figur 2 zeigt die erfindungsgemäße Zündeinrichtung gemäß Figur 1, ebenfalls mit Kunststoffkappe 9, Metallkappe 10 und Gegenstecker 4. Nicht eingezeichnet ist der Kunststoffmantel 7. Die Zündeinrichtung bildet mit den Bauelementen 51, 52 und 53 mit den auf dem Kunststoffkörper 11 aufgebrachten Leiterbahnen 113, dem Steckerkörper 3, der Rastnase 42, den Stekkeranschlußstiften 31 und insbesondere den Zündanschlußstiften 21 eine bauliche Einheit.

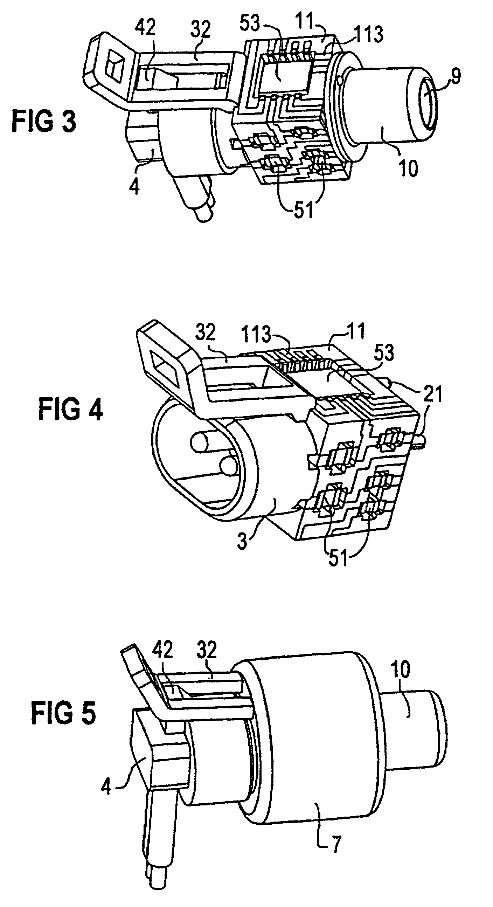

In Figur 3 ist die erfindungsgemäße Zündeinrichtung mit Gegenstecker 4 und Kunststoff- und Metallkappe 9,10 in zusammengebautem Zustand gezeigt. Die Bauelemente 51 bis 53 sind in Vertiefungen des Kunststoffkörpers 11 angeordnet, um weiteren Bauraum zu sparen. Die Bauelemente 51 bis 53 sind über Leiterbahnen 113 auf dem Kunststoffkörper 11 untereinander und mit den Zündanschlußstiften 21 und den Steckeranschlußstiften 31 elektrisch verbunden.

Figur 4 zeigt die Zündeinrichtung in perspektivischer Ansicht.

In Figur 5 ist die Zündeinrichtung sowohl mit Gegenstecker 4 als auch mit der Metallkappe 10 und Kunststoffmantel 7 in perspektivischer Darstellung gezeigt.

In Figur 6 ist die erfindungsgemäße Zündeinrichtung ohne Gegenstecker 4, ohne Kunststoffmantel 7, aber mit Metallkappe 10 neben einer herkömmlichen Zündpille 2 mit Steckerkörper 3 und Metallkappe 10 gezeigt. Dabei wird ersichtlich, daß durch die erfindungsgemäße Bauform der Zündeinrichtung die Ausmaße einer herkömmlichen Zündpille nur unwesentlich überschritten werden, obwohl die Zündeinrichtung eine Zündschaltung 5 mit diversen Bauelementen 51 bis 53 enthält.

Figur 8 zeigt als Träger für die erfindungsgemäße Zündeinrichtung eine aus einem Metallband gestanzte Leiterbahnstruktur 12, bei der die Steckeranschlußstifte 31 und die Zündanschlußstifte 21 integrierter Bestandteil der Leiterbahnstruktur 12 sind und damit in einem Arbeitsgang mit aus dem Metallband ausgestanzt werden.

Figur 9 zeigt die Leiterbahnstruktur 12 gemäß Figur 8, wobei einzelne Leiterzüge gebogen sind, so daß eine dreidimensionale Leiterbahnstruktur entsteht, die besonders platzsparend und kompakt ausgebildet ist.

In Figur 10 ist die gebogene Leiterbahnstruktur 12 gemäß Figur 9 gezeigt, wobei einzelne Leiterzüge über Kunststoffbrükken 121 miteinander verbunden sind. Durch diese Kunststoff-brücken 121 erhält die Leiterbahnstruktur 12 ausreichende mechanische Stabilität. Nach dem Umspritzen einzelner Leiterzüge mit den Kunststoffbrücken 121 können ferner unerwünschte leitende Verbindungen zwischen den Leiterzügen herausgestantzt werden. Ferner dienen die Kunststoffbrücken 121 zur Aufnahme und als Halterung von elektrischen Bauelementen 51 bis 53.

Figur 11 zeigt die Leiterbahnstruktur gemäß Figur 10 mit bestückten Bauelementen, beispielsweise einer integrierten Schaltung 53, den Energiespeicherkondensator 52 oder weiteren SMD-Bauelementen 51.

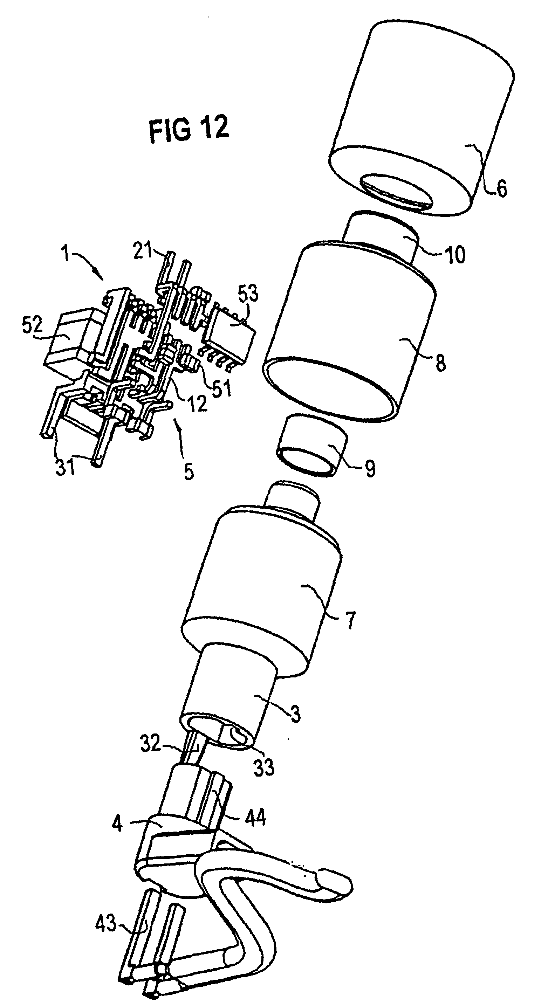

In Figur 12 wird ein solcher Träger 1 mit einer gestanzten Leiterbahnstruktur 12, der die Zündschaltung 5 trägt, zusammen mit diversen Ummantelungen 6 bis 10 und einem Gegenstekker 4 in Explosionsdarstellung gezeigt. Dabei wird die Leiterbahnstruktur 12 derart mit Kunststoff umspritzt, daß ein die Zündschaltung 5 vor Umwelteinflüssen schützender Kunststoffmantel 7 entsteht. Des weiteren wird im gleichen Arbeitsgang der Steckerkörper 3 an die Leiterbahnstruktur 12 mitangespritzt. Gleiches gilt für den Rasthaken 32 am Stekkerkörper 3. Der Steckerkörper 3 weist ferner eine Führung 33 auf, in die eine Nut 44 des Gegensteckers 4 bei eingeschobenem Gegenstecker 4 greift. Eine solche Codierung der Steckverbindung verhindert ein unsachgemäßes Zusammenstecken von Steckkörper 3 und Gegenstecker 4.

Der Kunststoffmantel 7 wird an seinem zündseitigen Ende mit einer Kunststoffkappe 9 zur Aufnahme des Zündpulvers abgedeckt. Träger 1 mit Kunststoffmantel 7 und die mit der Kunststoffkappe 9 ummantelten Zündanschlußstifte 21 sind von einem Metallmantel 8 und einer Metallkappe 10 ummantelt, die durchaus auch einstückig hergestellt werden können. Damit ist eine elektromagnetische Schirmung sowohl der Zündschaltung 5 als auch der Zündanschlußstifte 21 inclusive Zünddraht 22 gewährleistet. Der Metallmantel 8,10 schützt dient ferner als Wärmeableitung beim Zünden. Auf den Metallmantel 8 bzw. die Metallkappe 10 wird ein Gasgeneratormantel 6 aufgesetzt, in dessen Generatorkammer sich Tabletten zum Erzeugen von Gas befinden.

Anstelle der aufeinanderfolgenden Ummantelung einerseits der Zündanschlußstifte 21, andererseits der Zündschaltung 5 selbst mit einem Kunststoffmantel 7 und daraufhin einem Metallmantel 8, kann in beiden Fällen der Kunststoff- und der Metallmantel 7 und 8 durch einen einzigen Kunststoffmantel ersetzt werden, dessen erste Komponente einen isolierenden Kunststoff enthält, und dessen zweite Komponente einen elektrisch leitenden und damit schirmenden Kunststoff enthält. Insbesondere können Kunststoffmantel 7 und Kunststoffkappe 9 sowie Metallmantel 8 und Metallkappe 10 einstückig ausgebildet werden.

Das Anspritzen des Kunststoffmantels 7 an den Träger 1 unterstützt die mechanische Stabilität der Zündeinrichtung. Der Steckerkörper 3 kann anstelle mit dem Träger 1,11,12 und 121 auch einstückig mit dem Kunststoffmantel 7 hergestellt sein. Die Zündeinrichtung beziehungsweise die Zündanschlußstifte 21 können auch zuerst von einem Metallmantel 8,10 umgeben werden, welcher daraufhin wiederum mit Kunststoff 7,9 umspritzt wird, sodaß ein gegen Umwelteinflüsse dichter Kunststoffmantel entsteht.

Erfindungsgemäß wird durch die Ummantelung der Zündeinrichtung in vorteilhafter Weise eine einfache Befestigungsmöglichkeit für den Gasgenerator bewerkstelligt: Die mechanische Verbindung zwischen Kunststoffmantel und Gasgeneratormantel 6 beziehungsweise Metallmantel 8 und Gasgeneratormantel 6 kann über einen Flansch, eine Schnappverbindung oder eine sonstige herkömmliche Verbindung so gestaltet werden, daß die Zündeinrichtung beim Explodieren des Zündpulvers aufgrund des großen Rückdrucks nicht vom Gasgenerator gelöst wird und damit das Gasnicht in den Airbag strömt sondern nach Außen entweicht. Vorzugsweise kann auch das gesamte Gasgeneratorgehäuse einstückig mit der Ummantelung der Zündeinrichtung hergestellt werden, um damit eine auch unter Druck stabile Verbindung zwischen diesen beiden Bauteilen zu gewährleisten.

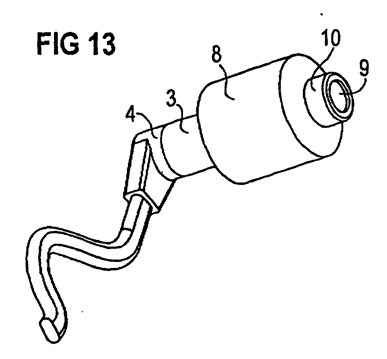

Figur 13 schließlich zeigt die erfindungsgemäße Zündeinrichtung gemäß Figur 12 mit Gegenstecker 4 und diversen Ummantelungen 8 bis 10 in zusammengebautem Zustand.

In vorteilhafter Weise ist zumindest ein metallisierter Bereich/Leiterbahnbereich des Trägers 1 möglichst nahe bei dem die Zündeinrichtung umgebenden Metallmantel 8 angeordnet. Der Abstand zwischen diesem metallisierten Bereich und dem Metallmantel 8 ist in jedem Fall geringer als der geringste Abstand zwischen dem Metallmantel 8, 10 und den Zündanschlußstiften 21 beziehungsweise dem Zünddraht 22: Damit wird gewährleistet, daß eine auf dem Metallmantel 8, 10 beziehungsweise auch dem Generatormantel 6 angeordnete große elektrische Ladung auf die Zündanschlußstifte 21 überspringt, damit einen Stromfluß durch den Zünddraht 22 verursacht und ggf das Zündpulver ungewollt zündet. Durch vorgenannte Maßnahme ist die sogenannte Funkenstrecke zwischen Metallmantel 8,10 und dem metallisierten Bereich auf dem Träger 1 kürzer als die Funkenstrecke zwischen Metallmantel 8, 10 und den Zündanschlußstiften 21, sodaß eine Ladung von dem Metallmantel 8,10 auf den metallisierte Bereich, nicht aber die Zündanschlußstifte 21 überspringt. Ein ungehindertes Weiterleiten der Ladung von dem metallisierten Bereich auf die Zündanschlußstifte 21 ist durch die dazwischen angeordnete Zündschaltung 5 ausgeschlossen. Vorzugsweise ist der metallisierte Bereich gleich den Steckeranschlußstiften 31.

Vorzugsweise wird an den Träger 1 eine Kunststoffwanne zur Aufnahme des Zündpulvers um die Zündanschlußstifte 21 gleich mitangespritzt.

## Patentansprüche

1. Zündeinrichtung zum Auslösen eines Rückhaltemittels in einem Kraftfahrzeug, mit einer Zündschaltung (5), **dadurch gekennzeichnet, daß** ein die Zündschaltung (5) enthaltender Träger (1) integrierte Zündanschlußstifte (21) zur unmittelbaren Aufnahme eines Zündelements aufweist.

2. Zündeinrichtung nach Anspruch 1, **dadurch gekennzeichnet, daß** die Zündanschlußstifte (21) über einen Zünddraht (22) elektrisch verbunden sind.

3. Zündeinrichtung nach Anspruch 1, **dadurch gekennzeichnet, daß** der Träger (1) ein aus einem Metallband gestanzte Leiterbahnstruktur (12) aufweist und daß die Zündanschlußstifte (21) einstückig mit der Leiterbahnstruktur (12) ausgebildet sind.

4. Zündeinrichtung nach Anspruch 1, **dadurch gekennzeichnet, daß** der Träger (1) als dreidimensionaler Kunststoffkörper (11) mit aufgebrachten Leiterbahnen (113) ausgebildet ist und daß die Zündanschlußstifte (21) fest mit dem Kunststoffkörper (11) verbunden sind.

5. Zündeinrichtung nach Anspruch 1, **dadurch gekennzeichnet, daß** der Träger (1) integrierte Steckeranschlußstifte (31) aufweist.

6. Zündeinrichtung nach Anspruch 1, **dadurch gekennzeichnet, daß** der Träger (1) von einem Kunststoffmantel (7) umgeben ist.

7. Zündeinrichtung nach Anspruch 1, **dadurch gekennzeichnet, daß** der Träger (1) von einem Metallmantel (8) umgeben ist.

8. Zündeinrichtung nach Anspruch 7, **dadurch gekennzeichnet, daß** der Abstand zwischen dem Metallmantel (8) und einer metallisierten Fläche des Trägers (1) geringer ist als der Abstand zwischen dem Metallmantel (8) und einem der Zündanschlußstifte (21).

9. Zündeinrichtung nach Anspruch 1, **dadurch gekennzeichnet, daß** die Zündanschlußstifte (21) unlösbarer Bestandteil des Trägers (1) sind.

## Claims

1. Firing device for triggering a restraining means in a motor vehicle, with a firing circuit (5), **characterized in that** a support (1) containing the firing circuit (5) has integrated firing terminal pins (21) for directly receiving a firing element.

2. Firing device according to Claim 1, **characterized in that** the firing terminal pins (21) are electrically connected via a firing wire (22).

3. Firing device according to Claim 1, **characterized in that** the support (1) has a conductor track structure (12), punched from a metal strip, and **in that** the firing terminal pins (31) are formed in one piece with the conductor track structure (12).

4. Firing device according to Claim 1, **characterized in that** the support (1) is formed as a three-dimensional plastic body (11) with applied conductor tracks (113) and **in that** the firing terminal pins (21) are solidly connected to the plastic body (11).

5. Firing device according to Claim 1, **characterized in that** the support (1) has integrated connector terminal pins (31).

6. Firing device according to Claim 1, **characterized in that** the support (1) is surrounded by a plastic jacket (7).

7. Firing device according to Claim 1, **characterized in that** the support (1) is surrounded by a metal jacket (8).

8. Firing device according to Claim 7, **characterized in that** the distance between the metal jacket (8) and a metallized surface of the support (1) is less than the distance between the metal jacket (8) and one of the firing terminal pins (21).

9. Firing device according to Claim 1, **characterized in that** the firing terminal pins (21) are an undetachable component part of the support (1).

## Revendications

1. Dispositif d'allumage permettant de libérer un système de retenue dans un véhicule à moteur, comportant un montage (5) d'allumage, **caractérisé en ce qu'**un élément (1) porteur contenant le montage (5) d'allumage comporte des broches (21) intégrées de branchement d'allumage pour recevoir directement un élément d'allumage.

2. Dispositif d'allumage suivant la revendication 1, **caractérisé en ce que** les broches (21) de branchement d'allumage sont reliées électriquement au moyen d'un fil (22) d'allumage.

3. Dispositif d'allumage suivant la revendication 1, **caractérisé en ce que** l'élément (1) porteur comporte une structure (12) de conducteurs imprimés, découpée dans une bande de tôle, et **en ce que** les broches (21) de branchement d'allumage sont réalisées d'un seul tenant avec la structure (12) de conducteurs imprimés.

4. Dispositif d'allumage suivant la revendication 1, **caractérisé en ce que** l'élément (1) porteur est réalisé sous forme de corps (11) en matière plastique à trois dimensions, sur lequel sont imprimés des conducteurs (113), et **en ce que** les broches (21) de branchement d'allumage sont fixement assemblées au corps (11) en matière plastique.

5. Dispositif d'allumage suivant la revendication 1, **caractérisé en ce que** l'élément (1) porteur comporte des broches (31) intégrées de branchement de connecteur.

6. Dispositif d'allumage suivant la revendication 1, **caractérisé en ce que** l'élément (1) porteur est entouré d'une enveloppe (7) en matière plastique.

7. Dispositif d'allumage suivant la revendication 1, **caractérisé en ce que** l'élément (1) porteur est entouré d'une enveloppe (8) en métal.

8. Dispositif d'allumage suivant la revendication 7, **caractérisé en ce que** la distance entre l'enveloppe (8) en métal et une face métallisée de l'élément (1) porteur est inférieure à la distance entre l'enveloppe (8) en métal et une des broches (21) de branchement d'allumage.

9. Dispositif d'allumage suivant la revendication 1, **caractérisé en ce que** les broches (21) de branchement d'allumage sont un constituant indétachable de l'élément (1) porteur.
